# EUROPÄISCHE PATENTSCHRIFT

(11) **EP 3 139 454 B1**
(45) Veröffentlichungstag und Bekanntmachung des Hinweises auf die Patenterteilung: **17.10.2018**
(21) Anmeldenummer: 16186380.8
(22) Anmeldetag: 30.08.2016
(51) Int. Cl.: H01R 31/06, H01R 35/04, H05K 5/02, H05K 5/00

(54) **ELEKTRISCHES GERÄT FÜR DIE MONTAGE IM INNERN EINES SCHALTSCHRANKS**
ELECTRICAL APPLIANCE FOR INSTALLATION WITHIN A SWITCHING CABINET
APPAREIL ELECTRIQUE DESTINE A ETRE INSTALLE DANS UNE ARMOIRE ELECTRIQUE

(30) Priorität: 01.09.2015 DE 102015114570
(43) Veröffentlichungstag der Anmeldung: 08.03.2017
(73) Patentinhaber: Rittal GmbH & Co. KG, 35745 Herborn (DE)
(72) Erfinder: Premysler, Ewgenij, 35745 Herborn (DE); Deusing, Marco, 35745 Herborn (DE); Schaffer, Kurt-Michael, 90542 Eckental (DE)
(74) Vertreter: Angerhausen, Christoph

(56) Entgegenhaltungen:
- US-A1- 2012 238 146
- US-B1- 7 255 582

## Beschreibung

Die Erfindung geht aus von einem elektrischen Gerät für die Montage im Innern eines Schaltschranks, das einen in einem Gehäuse des Geräts aufgenommenen ein- oder mehrpoligen Steckverbinder für den Anschluss eines elektrischen Leiters mit einer über mindestens eine Seite des Gehäuses frei zugänglichen Stecköffnung aufweist, wobei der mindestens eine Steckverbinder mindestens zwei unterschiedliche Stellpositionen in Bezug auf das Gehäuse einnehmen kann. Ein derartiges elektrisches Gerät ist beispielsweise aus der US 7,255,582 B1 bekannt. Ein ähnliches elektrisches Gerät zeigen auch die US 2012/0238146 A1, die DE 296 22 478 U1 sowie die DE 202 08 338 U1.

Ein solches elektrisches Gerät kann beispielsweise eine Schaltschrankleuchte sein, die im Innern eines Schaltschranks montiert ist. Bei den in Schaltschränken üblicherweise eingeschränkten Platzverhältnissen muss der elektrische Anschluss der Leuchte so angeordnet sein, dass die Herstellung einer Steckerverbindung von verschiedenen Richtungen aus möglich ist. Dies ist jedoch häufig immer noch mit einer ungünstigen Kabelführung verbunden, die bei den in Schaltschränken eingeschränkten Platzverhältnissen zu Anschlussproblemen führen kann.

Es ist daher die Aufgabe der Erfindung, ein elektrisches Gerät für die Montage im Innern eines Schaltschranks bereitzustellen, welches auch unter eingeschränkten Platzverhältnissen den einfachen Anschluss des Geräts an eine elektrische Stromversorgung erlaubt.

Diese Aufgabe wird erfindungsgemäß durch ein elektrisches Gerät mit den Merkmalen des Anspruchs 1 gelöst. Die abhängigen Ansprüche sind jeweils vorteilhafte Ausführungsformen der Erfindung.

Demgemäß kann bei dem vorgeschlagenen elektrischen Gerät der Steckverbinderin den mindestens zwei unterschiedlichen Stellpositionen eine Steckverbinderstirnseite eines Steckverbindergehäuses fluchtend mit derjenigen Gehäuseseite ausgerichtet sein, der der Steckverbinder mit seiner Stecköffnung zugewandt ist, wobei der Steckverbinder um eine Drehachse verschwenkbar in dem Gehäuse gelagert und über die Drehachse mit dem Gehäuse verbunden ist.

Auf diese Weise wird erreicht, dass je nach vorgefundenen Platzverhältnissen der Steckverbinder so verlagert werden kann, dass unter den gegebenen Umständen eine möglichst optimale Zugänglichkeit des Steckverbinders für einen Anschlussleiter erreicht wird.

Der Steckverbinder kann beispielsweise ein männlicher oder ein weiblicher Einbausteckverbinder sein, der in einer Seite des elektrischen Geräts verbaut ist.

Dadurch, dass der Steckverbinder um eine Drehachse verschwenkbar in dem Gehäuse gelagert und über die Drehachse mit dem Gehäuse verbunden ist, wird trotz der Beweglichkeit des Steckverbinders in dem Gehäuse erreicht, dass der Steckverbinder eine Zugentlastung im Hinblick auf seine elektrische Anbindung an eine elektrische Stromversorgung im Innern des Gehäuses, beispielsweise eine Platine und/oder einen Spannungswandler, besitzt.

Das Gehäuse kann eine Gehäuseecke aufweisen, an der eine erste und eine zweite Gehäuseseite ineinander übergehen. Die Gehäuseseiten können beispielsweise über eine Kante oder eine Rundung ineinander übergehen. Dabei kann vorgesehen sein, dass die Stecköffnung des Steckverbinders in einer ersten Position der ersten Gehäuseseite zugewandt ist und in einer zweiten Position der zweiten Gehäuseseite zugewandt ist. Die beiden Gehäuseseiten können zum Beispiel im Winkel von etwa 90° zueinander angeordnet sind, so dass der Steckverbinder wahlweise von zwei Raumrichtungen her, beispielsweise von der Seite und von oben, oder von vorne und von unten zugänglich ist, je nachdem, auf welche Weise die bessere Kabelführung erreicht werden kann.

Das Gehäuse kann auch zwei gegenüberliegende, parallel beabstandete Längsseiten aufweisen, wobei die Stecköffnung des Steckverbinders wiederum in einer ersten Stellposition der ersten Gehäuselängsseite zugewandt ist und in einer zweiten Stellposition der zweiten Gehäuselängsseite zugewandt ist. Dazu kann der Steckverbinder um etwa 180° um eine sich in Längsrichtung des Gehäuses erstreckende Drehachse zwischen der ersten und der zweiten Stellposition verschwenkbar sein. Zusätzlich kann die Stecköffnung des Steckverbinders in einer Zwischenposition, beispielsweise in einer Position, in der der Steckverbinder gegenüber der ersten und der zweiten Stellposition um jeweils etwa 90° um die Drehachse verdreht ist, einer weiteren, die beiden zuvor genannten Gehäuselängsseiten verbindenden Gehäuselängsseite zugewandt sein.

Die Gehäuseecke bzw. das Gehäuse kann eine Ausnehmung aufweisen, die über jeweils einen Zugang an beiden Gehäuse(längs-)seiten von außerhalb des Gehäuses zugänglich ist und in der der Steckverbinder aufgenommen ist.

Es ist weiterhin denkbar, dass der Steckverbinder ein Steckverbindergehäuse mit einer Verschlussseite aufweist, die, wenn die Stecköffnung des Steckverbinders einer der beiden Gehäuse(längs-)seiten zugewandt ist, zumindest anteilig den Zugang zu der Ausnehmung in der jeweils anderen Gehäuseseite nach außen verschließt. Dadurch wird erreicht, dass das Innere des Gehäuses, welches auch die elektrische Stromversorgung des Steckverbinders aufweisen kann, von außen nicht zugänglich ist, wodurch ein Berührungsschutz oder auch ein Schutz vor ungewolltem Eindringen von Verschmutzungen und Feuchtigkeit erreicht wird.

Das Gehäuse kann zumindest in einem endseitigen Gehäuseabschnitt, in dem der Steckverbinder in dem Gehäuse aufgenommen ist, im Wesentlichen quaderförmig ausgebildet sein. Dabei kann der Steckverbinder in einer ersten von zwei um etwa 90° zueinander versetzten Stellpositionen mit seiner Stecköffnung einer Stirnseite des Gehäuses zugewandt sein, wobei der Steckverbinder in einer zweiten der zwei um etwa 90° zueinander versetzten Stellpositionen mit seiner Stecköffnung einer Längsseite des Gehäuses zugewandt ist.

Weiterhin kann der Steckverbinder zumindest in den mindestens zwei unterschiedlichen Positionen in Bezug auf das Gehäuse jeweils eine Rastposition einnehmen.

Für die elektrische Kontaktierung des Steckverbinders mit einer Stromversorgung kann vorgesehen sein, dass der Steckverbinder im Innern des Gehäuses über flexible Leiter mit einer Stromversorgung verbunden ist. Der Steckverbinder kann darüber hinaus auch ganz allgemein mit einer elektrischen funktionalen Baugruppe elektrisch verbunden sein. Anstelle der flexiblen Leiter können auch Schleifkontakte vorgesehen sein, welche das Verlagern des Steckverbinders unter Beibehaltung der elektrischen Kontaktierung erlauben.

Des Weiteren kann das elektrische Gerät, beispielsweise an zwei gegenüber liegenden Seiten des Gehäuses jeweils einen Steckverbinder der zuvor beschriebenen Art aufweisen. Zwischen diesen Steckverbindern kann eine Durchkontaktierung durch das Gehäuse ausgebildet sein. Dabei können die beiden Steckverbinder identisch oder als ein männlicher und ein weiblicher Steckverbinder ausgebildet sein. Das elektrische Gerät kann beispielsweise an mindestens zwei voneinander beabstandeten Positionen des Gehäuses jeweils einen Steckverbinder aufweisen.

Weitere Einzelheiten der Erfindung werden anhand der nachstehenden Figuren erläutert. Dabei zeigt:
- Figur 1: schematisch eine erste Ausführungsform eines elektrischen Geräts, bei dem der Steckverbinder in zwei senkrecht zueinander ausgerichteten Positionen angeordnet ist;
- Figur 2: eine weitere Ausführungsform eines als Schaltschrankleuchte ausgebildeten elektrischen Geräts in perspektivischer Darstellung;
- Figur 3: eine Detailansicht der Ausführungsform gemäß Figur 2 im Bereich des Steckverbinders;
- Figur 4: eine weitere Ausführungsform eines elektrischen Geräts, bei dem zur Veranschaulichung der erfindungsgemäßen Funktion der Steckverbinder beispielhaft in drei unterschiedlichen Stellpositionen dargestellt ist;
- Figur 5: schematisch noch eine weitere Ausführungsform eines elektrischen Geräts, bei dem der Steckverbinder um eine sich in Längsrichtung des Geräts erstreckende Drehachse verschwenkbar ist;
- Figur 6: noch eine weitere Ausführungsform eines als Schaltschrankleuchte ausgebildeten elektrischen Geräts in perspektivischer Darstellung; und
- Figur 7: eine Detailansicht der Ausführungsform gemäß Figur 6 im Bereich des Steckverbinders.

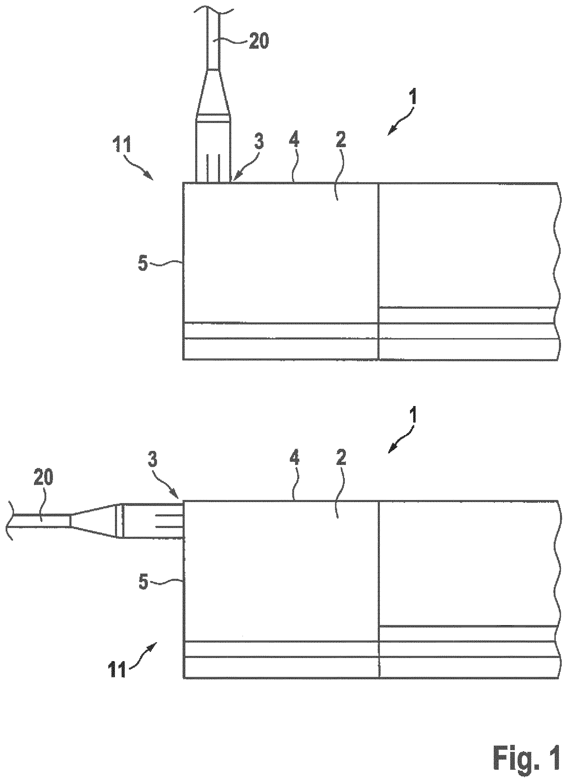

Die Figur 1 zeigt schematisch ein elektrisches Gerät, das lediglich beispielhaft als eine Schaltschrankleuchte dargestellt ist, wobei in einem endseitigen Gehäuseabschnitt 11 des Gehäuses 2 des elektrischen Geräts 1 ein um eine senkrecht zur Zeichnungsebene und senkrecht zu den vertikalen Längsseiten des Gehäuses 2 verlaufende Drehachse verschwenkbarer Steckverbinder 3 in einem Eckbereich des Gehäuses 2 aufgenommen ist. Je nachdem, wie eine bessere Kabelführung erreicht werden kann, kann das Anschlusskabel 20 entweder, wie in der oberen Darstellung gezeigt, von der Längsseite 4 dem elektrischen Gerät 1 zugeleitet werden, oder über seine Stirnseite 5 und dazu der Steckverbinder 3 entsprechend entweder der Stirnseite 5 oder der oberen Längsseite 4 zugewandt ausgerichtet werden. Das Anschlusskabel 20 weist endseitig einen männlichen oder weiblichen Stecker auf und der Steckverbinder 3 weist jeweils das entsprechende weibliche oder männliche Gegenstück auf.

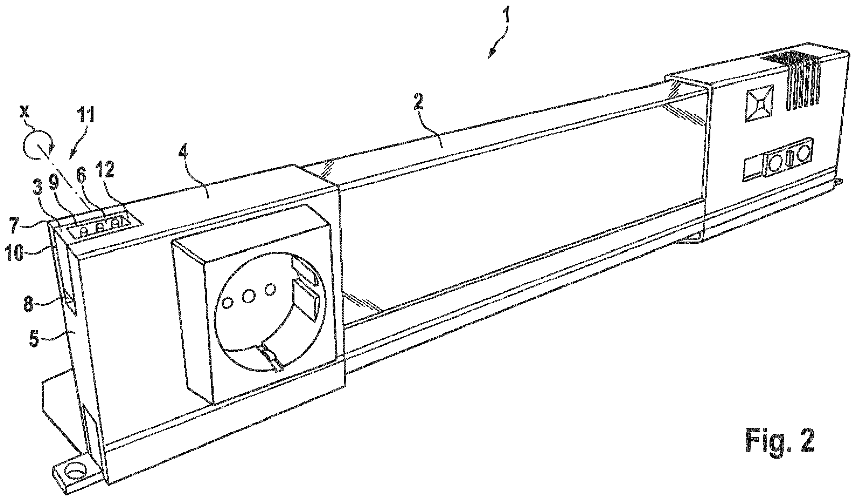

Die Figur 2 zeigt eine Ausführungsform, bei der das elektrische Gerät 1 als eine Schaltschrankleuchte ausgebildet ist. In dem endseitigen Gehäuseabschnitt 11, der im Wesentlichen quaderförmig ausgebildet ist, mit einer Längsseite 4, die über einen Eckbereich 7 in eine Stirnseite 5 übergeht, ist in dem Eckbereich 7 ein Steckverbinder 3 angeordnet, der erkennbar als männlicher Einbausteckverbinder ausgebildet ist. Der Steckverbinder 3 ist so ausgerichtet, dass seine Stecköffnung 6 der Längsseite 4 des endseitigen Gehäuseabschnitts 11 zugewandt ist. Die Ausnehmung 8, in der der Steckverbinder 3 aufgenommen ist, wird an der Stirnseite 5 zumindest größtenteils durch eine Verschlussseite 10 des Steckverbindergehäuses 9 verschlossen, wobei die Verschlussseite 10 gerade mit der Stirnseite 5 fluchtet. Ebenso fluchtet die Steckverbinderstirnseite 12, welche die Stecköffnung 6 aufweist, im Wesentlichen mit der Längsseite 4 des endseitigen Gehäuseabschnitts 11. Die Ausnehmung 8 könnte auch am gehäuseteil 11 eine einseitige Ausnehmung sein, so dass der Stecker auf einer Seite die Außenfläche des Gehäuses bildet.

Der Steckverbinder 3 ist analog zu der Ausführungsform gemäß Figur 1 wieder um eine Drehachse x derart verschwenkbar, so dass er mit seiner Stecköffnung 6 zwischen einer ersten, in Figur 2 dargestellten, Rastposition und einer zweiten Rastposition verschwenkt werden kann, in der die Stecköffnung 6 der Stirnseite 5 zugewandt ist und dementsprechend die Steckverbinderstirnseite 12 mit der Gehäusestirnseite 5 fluchtend oder annähernd fluchtend ausgerichtet ist. Der Steckverbinder ist somit wahlweise über die Längsseite 4 des Gehäuses 2 oder über die Stirnseite 5 des Gehäuses 2 zugänglich.

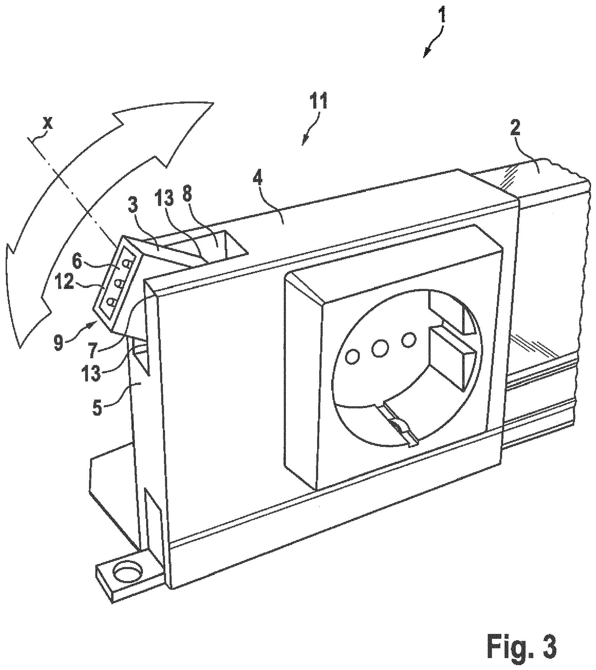

Die Figur 3 zeigt eine Ausschnittsvergrößerung der Ausführungsform gemäß Figur 2, wobei der Steckverbinder 3 in einer Zwischenstellung gezeigt ist, bei welcher die Steckverbinderstirnseite 12 weder mit der Längsseite 4 des Gehäuses 2 noch mit der Stirnseite 5 des Gehäuses fluchtend ausgerichtet ist. Es kann vorgesehen sein, dass der Steckverbinder 3 in den beiden vorgenannten Stellpositionen jeweils eine Rastposition einnimmt, so dass er, einmal aus diesen Rastpositionen ausgelöst, zwischen den Rastpositionen im Wesentlichen frei beweglich ist. Je nach Anwendung kann es auch sinnvoll sein, dass der Stecker in mindestens einer bestimmten Zwischenpositionen zwischen den zuvor genannten Rastpositionen jeweils eine Rastposition einnimmt. Die Figur 3 veranschaulicht, dass der Steckverbinder 3 in einer Ausnehmung 8 im Eckbereich 7 des endseitigen Gehäuseabschnitts 11 des Gehäuses 2 aufgenommen ist, welche sich zwischen der Längsseite 4 und der Stirnseite 5 einteilig erstreckt, wobei die Abmessungen der Ausnehmung 8 gerade so gewählt sind, dass der Steckverbinder 3 in jeder der beiden erwähnten Rastpositionen den jeweiligen Zugang 13 zu der Ausnehmung 8 an jeder der Seiten 4, 5, welcher die Steckverbinderstirnseite 12 des Steckverbinders 3 jeweils zugewandt ist, vollständig ausfüllt und damit verschließt (vgl. Figur 2).

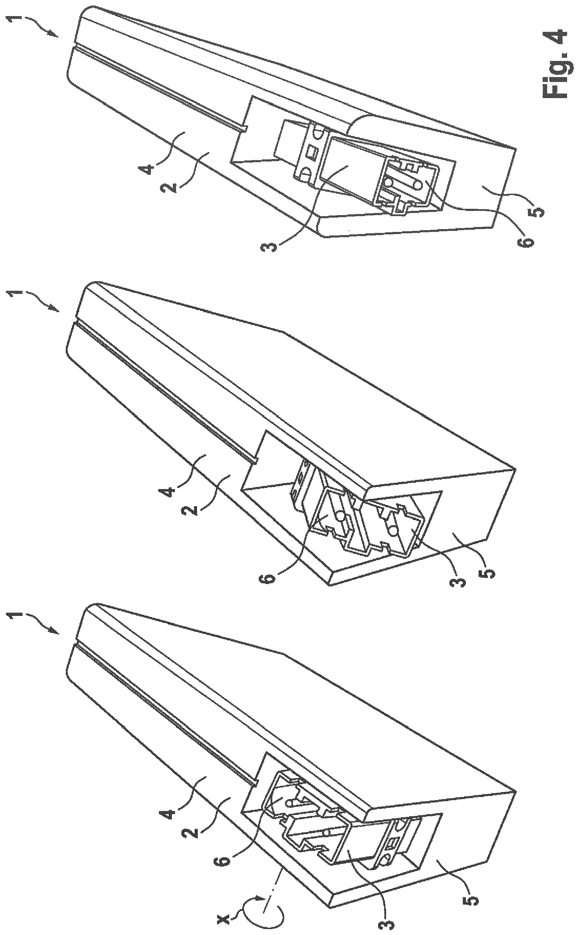

Die Figur 4 dient zur Veranschaulichung der unterschiedlichen Stellpositionen, die der Steckverbinder 3 bei einer Ausführungsform des erfindungsgemäßen elektrischen Geräts 1 einnehmen kann. Grundsätzlich ist der Steckverbinder 3 um die Drehachse x verschwenkbar zwischen der Position, die er in der linken Darstellung einnimmt, und der Position, die er in der rechten Darstellung einnimmt. Insbesondere kann der Steckverbinder 3 auch jede Zwischenposition einnehmen. Es kann jedoch vorgesehen sein, dass die in der linken Darstellung gezeigte Ausrichtung des Steckverbinders 3, bei der die Stecköffnung 6 der Längsseite 4 des Gehäuses 2 zugewandt ist, und die in der rechten Darstellung gezeigte Ausrichtung, bei der der Steckverbinder 3 der Stecköffnung 6 der Stirnseite 5 des Gehäuses 2 zugewandt ist, jeweils eine Rastposition aufweist.

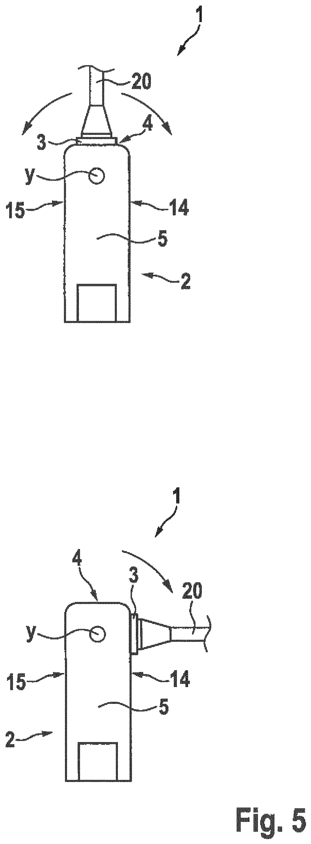

In Figur 5 ist schematisch eine weitere Ausführungsform des erfindungsgemäßen elektrischen Geräts 1 veranschaulicht. Im Gegensatz zu den in den vorangegangenen Figuren gezeigten Ausführungsformen ist bei dieser Ausführungsform der Steckverbinder 3 um eine Drehachse Y verdrehbar, welche sich in Längsrichtung des elektrischen Geräts 1 erstreckt. Wie auch in den vorangegangenen Ausführungsformen kann das elektrische Gerät 1 beispielsweise eine Schaltschrankleuchte sein. Das elektrische Gerät 1 soll jedoch nicht auf Schaltschrankleuchten beschränkt sein. In Figur 5 ist das elektrische Gerät 1 in der Draufsicht auf die Stirnseite 5 gezeigt.

Die beiden Darstellungen in Figur 5 zeigen, dass der Steckverbinder 3 um etwa 180° um die Drehachse Y verschwenkbar ist, so dass er in einer ersten Stellposition über eine erste Längsseite 4 für ein Anschlusskabel 20 zugänglich ist. In der unteren Darstellung von Figur 5 ist die Stellposition des Steckverbinders 3 gezeigt, bei der der Steckverbinder 3 über eine von zwei parallel beabstandeten Längsseiten 14, 15 zugänglich ist. Analog zu der in der unteren Darstellung von Figur 5 gezeigten Stellposition des Steckverbinders 3 kann der Steckverbinder 3 auch dazu um etwa 180° verdreht angeordnet sein, so dass er über die weitere Längsseite 15 der beiden parallel beabstandeten Längsseiten 14, 15 zugänglich ist.

Wie in Figur 5 dargestellt ist, eignet sich diese Ausführungsform insbesondere für elektrische Geräte 1 deren Gehäuse 2 zumindest abschnittsweise im Längsquerschnitt rechteckig ausgebildet ist, so dass das Gehäuse 2 die genannten beiden parallel beabstandeten Längsseiten 14, 15 aufweist und darüber hinaus eine weitere Längsseite 4, welche die beiden parallel beabstandeten Längsseiten 14, 15 miteinander verbindet und vorzugsweise rechtwinklig zu diesen angeordnet ist.

Der Steckverbinder 3 kann in den drei genannten Ausrichtungen, bei denen er jeweils einer der Längsseiten 4, 14, 15 zugewandt ist, so dass der Steckverbinder 3 über die jeweilige Längsseite 4, 14, 15 zugänglich ist, jeweils eine Rastposition aufweisen. Darüber hinaus kann der Steckverbinder 3 auch in Zwischenpositionen Rastpositionen einnehmen. Die in Figur 5 gezeigte Ausführungsform weist somit eine besonders hohe Variabilität im Hinblick auf die Zuführungsrichtung des Anschlusskabels 20 auf.

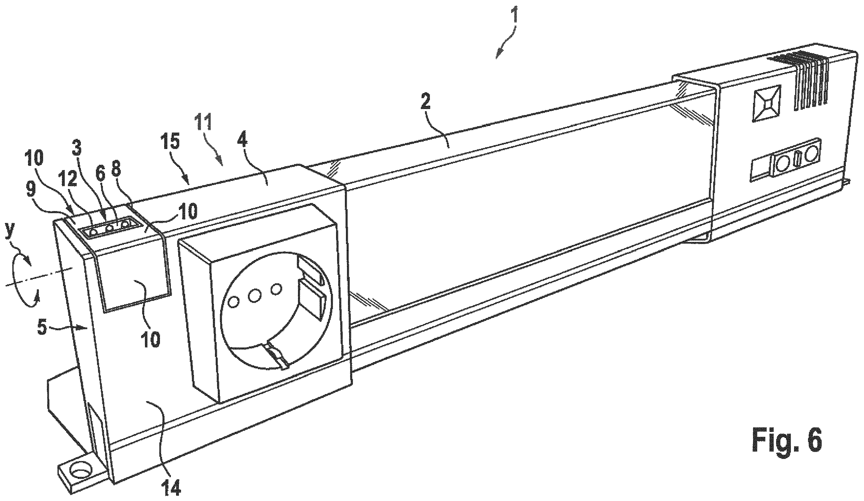

Die Figur 6 zeigt eine konkrete Ausgestaltung der in Figur 5 schematisch dargestellten Ausführungsform. Hierbei ist der Steckverbinder 3 in einem Steckverbindergehäuse 9 aufgenommen, das sich in einem endseitigen Gehäuseabschnitt 11 des Gehäuses 2 des elektrischen Geräts 1, hier als Schaltschrankleuchte ausgebildet, befindet. In der in Figur 6 dargestellten Stellposition ist die Stecköffnung 6 des Steckverbinders 3 der Längsseite 4 zugewandt ausgerichtet, so dass die Stecköffnung 6 für ein Anschlusskabel (nicht dargestellt) über die Längsseite 4 zugänglich ist. Des Weiteren ist das Steckverbindergehäuse 9 so ausgebildet, dass es die Ausnehmung 8 in der das Steckverbindergehäuse 9 aufgenommen ist, vollständig ausfüllt und insbesondere seine Gehäuseseiten 10 jeweils fluchtend zu den jeweiligen Längsseiten 4, 14, 15 des endseitigen Gehäuseabschnitts 11 angeordnet sind. Des Weiteren ist die Steckverbinderstirnseite 12 fluchtend zu der Längsseite 4 angeordnet.

Das Steckverbindergehäuse 3 ist analog zu der in Figur 5 gezeigten Ausführungsform um eine Drehachse Y verdrehbar, welche sich in Längsrichtung des Gehäuses 2 beziehungsweise des endseitigen Gehäuseabschnitts 11 erstreckt.

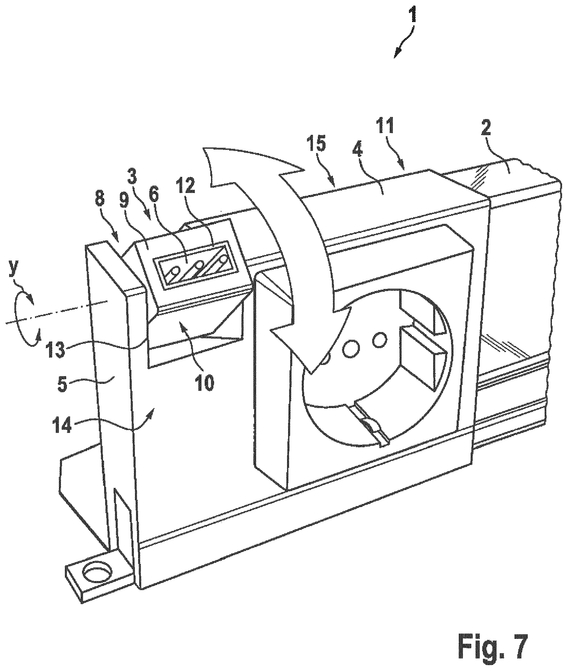

In Figur 7 ist zur Veranschaulichung eine Detailansicht der Figur 6 gezeigt, bei der das Steckverbindergehäuse 9 um ca. 45° aus der in Figur 6 gezeigten Position verschwenkt ist. Das Steckverbindergehäuse 9 ist um etwa ° zwischen den beiden Stellpositionen verstellbar, bei denen die Stecköffnung 6 einmal in der Ebene der in der Darstellung gemäß Figur 7 vorderen Längsseite 14 angeordnet ist, und einmal in der Ebene der gegenüberliegenden Längsseite 15 angeordnet ist.

In dem teilverschwenkten Zustand, wie er in Figur 7 gezeigt ist, ist auch zu erkennen, dass das Steckverbindergehäuse 9 in einer Ausnehmung 8 in dem endseitigen Gehäuseabschnitt 11 aufgenommen ist, wobei der Vergleich mit Figur 6 zeigt, dass die Abmessungen des Steckverbindergehäuses 9 und der Ausnehmung 8 gerade so aufeinander abgestimmt sind, dass das Steckverbindergehäuse zumindest in der in Figur 6 dargestellten Stellposition die Ausnehmung vollständig ausfüllt, so dass die sichtbaren Flächen des Steckverbindergehäuses mit den Längsseiten 4, 14, 15 des endseitigen Gehäuseabschnitts 11 fluchten.

### Bezugszeichenliste:

- 1: Elektrisches Gerät
- 2: Gehäuse
- 3: Steckverbinder
- 4: Längsseite
- 5: Stirnseite
- 6: Stecköffnung
- 7: Gehäuseecke
- 8: Ausnehmung
- 9: Steckverbindergehäuse
- 10: Verschlussseite
- 11: endseitiger Gehäuseabschnitt
- 12: Steckverbinderstirnseite
- 13: Zugang
- 20: Anschlusskabel
- X: Drehachse

## Patentansprüche

1. Elektrisches Gerät (1) für die Montage im Innern eines Schaltschranks, das mindestens einen in einem Gehäuse (2) des Geräts (1) aufgenommenen ein- oder mehrpoligen Steckverbinder (3) für den Anschluss eines elektrischen Leiters mit einer über eine Seite (4, 5, 14, 15) des Gehäuses (2) frei zugänglichen Stecköffnung (6) aufweist, wobei der mindestens eine Steckverbinder (3) mindestens zwei unterschiedliche Stellpositionen in Bezug auf das Gehäuse (2) einnehmen kann, **dadurch gekennzeichnet, dass** in den mindestens zwei unterschiedlichen Stellpositionen eine Steckverbinderstirnseite (12) eines Steckverbindergehäuses (9) fluchtend mit derjenigen Gehäuseseite (4, 5, 14, 15) ausgerichtet ist, der der Steckverbinder (3) mit seiner Stecköffnung (6) zugewandt ist, wobei der Steckverbinder (3) um mindestens eine Drehachse (X, Y) verschwenkbar in dem Gehäuse (2) gelagert und über die Drehachse (X, Y) mit dem Gehäuse (2) verbunden ist.

2. Elektrisches Gerät (1) nach Anspruch 1, bei dem das Gehäuse (2) eine Gehäuseecke (7) aufweist, an der eine erste und eine zweite Gehäuseseite (4, 5) ineinander übergehen, wobei die Stecköffnung (6) des Steckverbinders (3) in einer ersten Stellposition der ersten Gehäuseseite (4) zugewandt ist, und wobei die Stecköffnung (6) des Steckverbinders (3) in einer zweiten Stellposition der zweiten Gehäuseseite (5) zugewandt ist.

3. Elektrisches Gerät (1) nach Anspruch 2, bei dem die Gehäuseecke (7) eine Ausnehmung (8) aufweist, die über jeweils einen Zugang (13) an beiden Gehäuseseiten (4, 5) von außerhalb des Gehäuses (2) zugänglich ist und in der der Steckverbinder (3) aufgenommen ist.

4. Elektrisches Gerät (1) nach Anspruch 2 oder 3, bei dem das Gehäuse (2) zumindest in einem endseitigen Gehäuseabschnitt (11), in dem der Steckverbinder (3) in dem Gehäuse (2) aufgenommen ist, im Wesentlichen quaderförmig ausgebildet ist, wobei der Steckverbinder (3) in einer ersten von zwei um 90° zueinander versetzten Stellpositionen mit seiner Stecköffnung (6) einer Stirnseite (5) des Gehäuses (2) zugewandt ist, und wobei der Steckverbinder (3) in einer zweiten der zwei um 90° zueinander versetzten Stellpositionen mit seiner Stecköffnung (6) einer Längsseite (4) des Gehäuses (2) zugewandt ist.

5. Elektrisches Gerät (1) nach Anspruch 1, bei dem das Gehäuse zwei gegenüberliegende, parallel beabstandete Gehäuselängsseiten (14, 15) aufweist, wobei die Stecköffnung (6) des Steckverbinders (3) in einer ersten Stellposition einer ersten der beiden Gehäuselängsseiten (14, 15) und in einer zweiten Stellposition einer zweiten der beiden Gehäuselängsseiten (14, 15) zugewandt ist.

6. Elektrisches Gerät (1) nach Anspruch 5, bei dem der Steckverbinder um 180° um eine sich in Längsrichtung des Gehäuses (2) erstreckende Drehachse (Y) zwischen der ersten und der zweiten Stellposition verschwenkbar ist.

7. Elektrisches Gerät (1) nach Anspruch 6, bei dem die Stecköffnung (6) des Steckverbinders (3) in einer Zwischenposition, in der der Steckverbinder (3) gegenüber der ersten und der zweiten Stellposition um jeweils 90° um die Drehachse (Y) verdreht ist, einer weiteren, die beiden Gehäuselängsseiten (14, 15) verbindenden Gehäuselängsseite (14, 15) zugewandt ist.

8. Elektrisches Gerät (1) nach einem der Ansprüche 2 bis 7, bei dem das Gehäuse (2) eine Ausnehmung (8) aufweist, die über jeweils einen Zugang (13) an beiden Gehäuseseiten (4, 5, 14, 15) von außerhalb des Gehäuses (2) zugänglich ist und in der der Steckverbinder (3) aufgenommen ist, und bei dem der Steckverbinder (3) ein Steckverbindergehäuse (9) und eine Verschlussseite (10) aufweist, die, wenn die Stecköffnung (6) des Steckverbinders (3) einer der beiden Gehäuseseiten (4, 5, 14, 15) zugewandt ist, zumindest anteilig den Zugang (13) zu der Ausnehmung (8) in der jeweils anderen Gehäuseseite (4, 5) nach außen verschließt.

9. Elektrisches Gerät nach einem der vorangegangen Ansprüche, bei dem der Steckverbinder (3) zumindest in den mindestens zwei unterschiedlichen Stellpositionen in Bezug auf das Gehäuse (2) jeweils eine Rastposition einnimmt.

10. Elektrisches Gerät nach einem der vorangegangen Ansprüche, bei dem der Steckverbinder (3) im Innern des Gehäuses (2) über flexible Leiter oder über eine Zwischenplatine mit einer Stromversorgung verbunden ist.

11. Elektrisches Gerät nach einem der vorangegangen Ansprüche, das an mindestens zwei voneinander beabstandeten Positionen des Gehäuses (2) jeweils einen Steckverbinder (6) aufweist.

## Claims

1. Electrical device (1) for installation in the interior of an electrical enclosure that has at least one single- or multi-pole plug (3) accommodated in a housing (2) of the device (1) for connecting an electrical conductor to a plug opening easily accessible via one side (4, 5, 14, 15) of the housing (2), wherein the at least one plug (3) can assume no less than two different positions or orientations with respect to the housing (2), **characterized in that** in the no less than two different positions or orientations that the plug (3) can assume with respect to the housing (2), a plug end face (12) of a plug case (9) is aligned with that housing side (4, 5, 14, 15) which the plug (3) faces with its plug opening (6), wherein the plug (3) can be pivoted about at least one axis of rotation (X, Y) in the housing (2) and is connected to the housing (2) via the axis of rotation (X, Y).

2. The electrical device (1) according to claim 1, in which the housing (2) has a housing corner (7) where a first and second housing side (4, 5) merge, wherein the plug opening (6) of the plug (3) faces the first housing side (4) in a first position or orientation, and wherein the opening (6) of the plug (3) faces the second housing side (5) in a second position or orientation.

3. The electrical device (1) according to claim 2, in which the corner of the housing (7) has a recess (8) that is accessible via an access (13) on both sides of the housing (4, 5) from outside the housing (2) and in which the plug (3) is accommodated.

4. The electrical device (1) according to claim 2 or 3, in which the housing (2) is configured essentially rectangular at least in a housing end face section (11) in which the plug (3) is accommodated in the housing (2), wherein the plug (3), in a first of two rotational positions offset to each other by 90°, faces one end face (5) of the housing (2) with its plug opening (6) and wherein the plug (3), in a second of the two rotational positions offset to each other by 90°, faces a longitudinal side (4) of the housing (2) with its plug opening (6).

5. The electrical device (1) according to claim 1, in which the housing (2) has two longitudinal housing sides (14, 15), spaced parallel to and opposite each other, wherein the plug opening (6) of the plug (3) in a first engaged position or orientation faces a first of the two longitudinal housing sides (14, 15) and in a second engaged position or orientation faces a second of the two longitudinal housing sides (14, 15).

6. The electrical device (1) according to claim 5, in which the plug can be pivoted by 180° about an axis of rotation (Y) extending in the longitudinal direction of the housing (2) between the first and the second engaged position or orientation.

7. The electrical device (1) according to claim 6, wherein the plug opening (6) of the plug (3) in an intermediate position, in which the plug (3), compared with the first and the second engaged position or orientation, is rotated by 90° about the axis of rotation (Y), faces an additional housing longitudinal side (14, 15) which connects the two housing longitudinal sides (4).

8. The electrical device (1) according to one of the claims 2 to 7, wherein the housing (2) has a recess (8) which is accessible from a respective access (13) on both longitudinal sides (4, 5, 14, 15) from the exterior of the housing (2) and in which the plug (3) is accommodated, and in which the plug (3) has a plug case (9) and a closing side (10), which, when the opening (6) of the plug (3) faces one of the two housing sides (4, 5, 14, 15), at least partially closes off the access (13) to the recess (8) in the respective other housing side (4, 5) to the outside.

9. The electrical device (1) according to one of the preceding claims, wherein the plug (3) assumes an engaged position at least in the no less than two different positions or orientations with respect to the housing (2).

10. The electrical device (1) according to one of the preceding claims, wherein the plug (3) is connected in the interior of the housing (2) via flexible conductors or via an intermediate PCB to a power supply.

11. The electrical device (1) according to one of the preceding claims, which has a plug (6) in at least two spaced apart positions of the housing (2).

## Revendications

1. Appareil électrique (1) destiné à être monté à l'intérieur d'une armoire de commande, qui comprend au moins un connecteur (3) monopolaire ou multipolaire logé dans un boîtier (2) de l'appareil (1), pour le raccordement d'un conducteur électrique avec une ouverture d'enfichage (6) librement accessible par une face (4, 5, 14, 15) du boîtier (2), l'au moins un connecteur (3) pouvant adopter au moins deux positions de réglage différentes par rapport au boîtier (2), **caractérisé en ce que**, dans les au moins deux différentes positions de réglage, une face frontale de connecteur (12) d'un boîtier de connecteur (9) est alignée avec la face du boîtier (4, 5, 14, 15) qui est orientée vers le connecteur (3) avec son ouverture d'enfichage (6), le connecteur (3) étant logé de manière pivotante autour d'au moins un axe de rotation (X, Y) dans le boîtier (2) et étant relié avec le boîtier (2) par l'intermédiaire de l'axe de rotation (X, Y).

2. Appareil électrique (1) selon la revendication 1, dans lequel le boîtier (2) comprend un angle de boîtier (7) au niveau duquel une première et une deuxième face du boîtier (4, 5) se succèdent l'un à l'autre, l'ouverture d'enfichage (6) du connecteur (3) étant orientée, dans une première position de réglage, vers le premier côté du boîtier (4) et l'ouverture d'enfichage (6) du connecteur (3) étant orientée, dans une deuxième position de réglage, vers le deuxième côté du boîtier (5).

3. Appareil électrique (1) selon la revendication 2, dans lequel l'angle de boîtier (7) comprend un évidement (8) qui est accessible, par un accès (13) sur chacune des deux faces du boîtier (4, 5), de l'extérieur du boîtier (2) et dans lequel est logé le connecteur (3).

4. Appareil électrique (1) selon la revendication 2 ou 3, dans lequel le boîtier (2), au moins dans une portion de boîtier d'extrémité (11), dans laquelle le connecteur (3) est logé dans le boîtier (2), présente une forme globalement parallélépipédique, le connecteur (3) étant orienté, dans une première de deux positions de réglage décalées entre elles de 90°, avec son ouverture d'enfichage (6), vers une face frontale (5) du boîtier (2) et le connecteur (3) étant orienté, dans une deuxième de deux positions de réglage décalées entre elles de 90°, avec son ouverture d'enfichage (6), vers une face longitudinale (4) du boîtier (2).

5. Appareil électrique (1) selon la revendication 1, dans lequel le boîtier comprend deux faces longitudinales de boîtier (14, 15) parallèles opposées, l'ouverture d'enfichage (6) du connecteur (3) étant orientée, dans une première position de réglage, vers une première des deux faces longitudinales du boîtier (14, 15) et, dans une deuxième position de réglage, vers une deuxième des deux faces longitudinales du boîtier (14, 15).

6. Appareil électrique (1) selon la revendication 5, dans lequel le connecteur peut pivoter de 180° autour d'un axe de rotation (Y) s'étendant dans la direction longitudinale du boîtier (2), entre la première et la deuxième position de réglage.

7. Appareil électrique (1) selon la revendication 6, dans lequel l'ouverture d'enfichage (6) du connecteur (3) est orientée, dans une position intermédiaire, dans laquelle le connecteur (3) est tourné de 90° autour de l'axe de rotation (Y) par rapport à la première et à la deuxième position de réglage, vers une autre face longitudinale du boîtier (14, 15) reliant les deux faces longitudinales (14, 15).

8. Appareil électrique (1) selon l'une des revendications 2 à 7, dans lequel le boîtier (2) comprend un évidement (8) qui est accessible de l'extérieur du boîtier (2) par l'intermédiaire d'un accès (13) sur chacune des deux faces longitudinales (4, 5, 14, 15), et dans lequel le connecteur est logé, et dans lequel le connecteur (3) comprend un boîtier de connecteur (9) et une face de fermeture (10) qui, lorsque l'ouverture d'enfichage (6) du connecteur (3) est orientée vers une des deux faces du boîtier (4, 5, 14, 15), obture au moins partiellement l'accès (13) à l'évidement (8) dans l'autre face de boîtier (4, 5) vers l'extérieur.

9. Appareil électrique (1) selon l'une des revendications précédentes, dans lequel le connecteur (3) adopte, au moins dans des au moins deux différentes positions de réglage, par rapport au boîtier (2) une position d'encliquetage.

10. Appareil électrique (1) selon l'une des revendications précédentes, dans lequel le connecteur (3) est relié, à l'intérieur du boîtier (2), par l'intermédiaire de conducteurs flexibles ou d'une platine intermédiaire, avec une alimentation en courant.

11. Appareil électrique (1) selon l'une des revendications précédentes, qui comprend, au niveau de chacune d'au moins deux positions, écartées entre elles, du boîtier (12), un connecteur (6).
